# EUROPEAN PATENT APPLICATION

(11) **EP 1 650 262 A1**
(43) Date of publication of application: **26.04.2006**
(21) Application number: 05256291.5
(22) Date of filing: 10.10.2005
(51) Int. Cl.: C08L 79/08, C08K 3/00, C08K 3/34

(54) **Polyetherimide composition, film, process, and article**

(30) Priority: 19.10.2004 US 968733
(71) Applicant: GENERAL ELECTRIC COMPANY, Schenectady, New York 12345 (US)
(72) Inventor: Blackburn, Sapna, Mt. Vernon Indiana 47620 (US); Dris, Irene, Clifton Park New York 12065 (US); Sheth, Kapil Chandrakant, Evansville Indiana 47712 (US); Croll, Joshua, Latham New York 12110 (US); Gurel, Emine Elif, Evansville Indiana 47712 (US)
(74) Representative: Szary, Anne Catherine

(57) **Abstract**

A polymer composition comprising, by weight, from about 50% to about 95% polyetherimide resin and from about 5% to about 50% inorganic substance. The polymer composition when formed into a film has a coefficient of thermal expansion of less than about 50 ppm/°C.

## Description

### BACKGROUND

High performance polymer compositions that include polyetherimide (PEI) are widely used in high temperature environments because polyetherimide possesses excellent dimensional and thermal stability. For example, polymer compositions containing polyetherimide are often used in electrical applications across a wide variety of industries such as the telecommunication and automotive industries, because polyetherimide has excellent properties, such as, a low dielectric constant, low flammability and low moisture absorption. Specifically, in flexible printed circuit (FPC) applications, polymer compositions containing polyetherimide can be used as a film that is a base substrate for flex circuitry. In such case it is desirable that the coefficient of thermal expansion (CTE) approximate the CTE of other constituent layers in the laminate in order to avoid delamination, curling and wrinkling upon changes in temperature. As temperature requirements and the rate of heat dissipation increase in higher performance applications, the increased changes in temperature during thermal cycling requires that the polymer film more closely approximate those of other constituent layers, for example, a layer of copper which can be laminated onto the polymer substrate. Applications such as FPC may also require that the film maintain consistent physical and electrical properties throughout and that the surface roughness of the film be low for good processability in secondary applications, for example, in constructing laminates. It is therefore desirable to create a polymer composition with improved dimensional stability for use in a variety of applications.

### SUMMARY

The present invention provides for polymer compositions that when converted into a film have improved dimensional stability. In one embodiment the polymer composition includes, by weight, from about 50% to about 95% polyetherimide resin, and from about 5% to about 50% inorganic substance. The polymer composition, when formed into a film, has a coefficient of thermal expansion (CTE) that is less than about 50 ppm/°C.

In another embodiment the present invention provides for film comprising from about 50% to about 95% polyetherimide and from about 5% to about 50% inorganic substance. The film has an average roughness of less than 2.0 microns according to ANSI B46.1.

A process for making the polymer film includes preparing a solution containing the polymer composition described above, casting a layer of the solution onto a substrate, and removing solvent, for example via evaporation, from the layer of solution. In another embodiment the above polymer film is made by extruding the polymer composition to form a film having a thickness of about 750 microns or less.

The present invention also provides for an article having a film layer described above disposed on the substrate. The film provides for improved dimensional stability of the laminate during thermal cycling.

### DETAILED DESCRIPTION

It has been discovered that a polymer composition that includes polyetherimide and from about 5% to about 50% by weight inorganic substances can be made into a film having improved thermal stability. In one embodiment the polyetherimide composition of the present invention includes, by weight, from about 50% to about 95%, in alternative embodiments, from about 60% to about 90%, in other embodiments, from about 65% to about 85%, and in yet alternative embodiments from about 60% to about 70% polyetherimide; and from about 5% to about 50%, in an alternative embodiment, from about 10% to about 40%, in another embodiment, from about 15% to about 35%, and in yet an alternative embodiment from about 20% to about 30% inorganic substance, and all subranges therebetween.

It has been found that the polymer composition of the present invention has a CTE that is less than about 50 ppm/°C, in some embodiments from about 24 to about 48 ppm/°C, and in alternative embodiments from about 34 to about 48 ppm/°C, and yet other embodiments from about 34 to about 39 ppm/°C, and all subranges therebetween. When the polymer composition is formed into a film for example, about 750 microns or less, the average surface roughness (Ra) is less than about 2.0 microns as measured according to ANSI B46.1, depending upon the amount of inorganic substances in the polymer compound.

The polyetherimide resins suitable for use in this invention include polyetherimides well known in the art and described in, for example, U.S. Pat. Nos. 3,803,085, 3,838,097, 3,847,867, 3,905,942 and 4,107,147. Polyetherimide resins comprise more than 1, typically about 10 to about 1,000 or more, and more specifically about 10 to about 500 structural units, of the Formula (I): 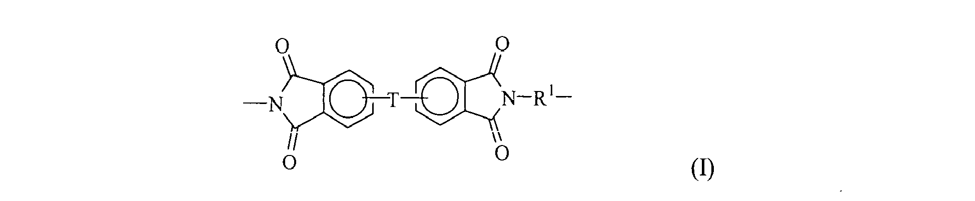 wherein T and R¹ are independently selected from substituted and unsubstituted divalent aromatic radicals. In one embodiment T is -O- or a group of the Formula -O-Z-O- wherein the divalent bonds of the -O- or the -O-Z-O- group are in the 3,3', 3,4', 4,3', or the 4,4' positions, and wherein Z includes, but is not limited, to divalent radicals of Formula (II): 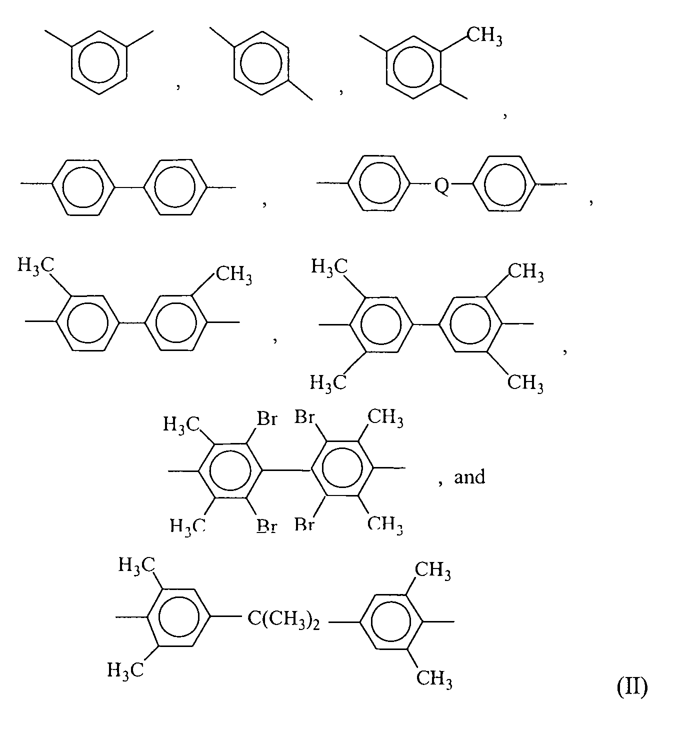 wherein Q includes, but is not limited to, a divalent moiety comprising -O-, -S-, - C(O)-, -SO₂-, -SO-, -C_{y}H_{2y}- (y being an integer from 1 to 5), and halogenated derivatives thereof, including but not limited to the perfluoroalkylene groups, or a group of the formula -O-Z-O- wherein the divalent bonds of the -O- or the -O-Z-O-group are in the 3,3', 3,4', 4,3', or the 4,4' positions, and wherein Z includes, but is not limited, to divalent radicals of Formula (II).

R¹ in formula (I) includes, but is not limited to, substituted or unsubstituted divalent organic radicals such as: aromatic hydrocarbon radicals having about 6 to about 20 carbon atoms and halogenated derivatives thereof; straight or branched chain alkylene radicals having about 2 to about 20 carbon atoms; cycloalkylene radicals having about 3 to about 20 carbon atoms; or divalent radicals of the general formula (III)

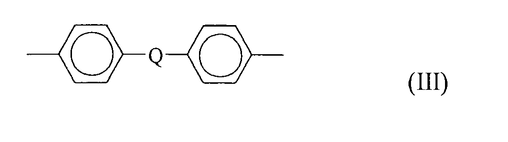

The polyetherimide can be prepared by any of a variety of methods, including the reaction of an aromatic bis(ether anhydride) of the Formula (IV) 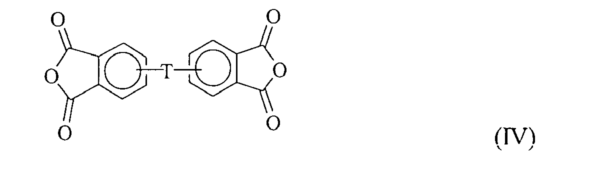 with an organic diamine of the Formula (V)

H₂N-R¹-NH₂ (V)

wherein T and R¹ are defined in relation to Formulas (I) and (III), respectively. The polyetherimides of Formula (I) may be copolymerized with other polymers such as polyesters, polycarbonates, polyacrylates, fluoropolymers, and the like.

Examples of specific aromatic bis(ether anhydride)s and organic diamines are disclosed, for example, in U.S. Patent Nos. 3,972,902 and 4,455,410. Illustrative examples of aromatic bis(ether anhydride)s of Formula (I) include:
2,2-bis[4-(3,4-dicarboxyphenoxy)phenyl]propane dianhydride; 4,4'-bis(3,4-dicarboxyphenoxy)diphenyl ether dianhydride; 4,4'-bis(3,4-dicarboxyphenoxy)diphenyl sulfide dianhydride; 4,4'-bis(3,4-dicarboxyphenoxy)benzophenone dianhydride; 4,4'-bis(3,4-dicarboxyphenoxy)diphenyl sulfone dianhydride; 2,2-bis[4-(2,3-dicarboxyphenoxy)phenyl]propane dianhydride; 4,4'-bis(2,3-dicarboxyphenoxy)diphenyl ether dianhydride; 4,4'-bis(2,3-dicarboxyphenoxy)diphenyl sulfide dianhydride; 4,4'-bis(2,3-dicarboxyphenoxy)benzophenone dianhydride; 4,4'-bis(2,3-dicarboxyphenoxy)diphenyl sulfone dianhydride; 4-(2,3-dicarboxyphenoxy)-4'-(3,4-dicarboxyphenoxy)diphenyl-2,2-propane dianhydride; 4-(2,3-dicarboxyphenoxy)-4'-(3,4-dicarboxyphenoxy)diphenyl ether dianhydride; 4-(2,3-dicarboxyphenoxy)-4'-(3,4-dicarboxyphenoxy)diphenyl sulfide dianhydride; 4-(2,3-dicarboxyphenoxy)-4'-(3,4-dicarboxyphenoxy)benzophenone dianhydride and 4-(2,3-dicarboxyphenoxy)-4'-(3,4-dicarboxyphenoxy)diphenyl sulfone dianhydride, as well as mixtures comprising at least two of the foregoing.

The bis(ether anhydride)s can be prepared by the hydrolysis, followed by dehydration, of the reaction product of a nitro substituted phenyl dinitrile with a metal salt of dihydric phenol compound in the presence of a dipolar, aprotic solvent. A preferred class of aromatic bis(ether anhydride)s included by Formula (I) above includes, but is not limited to, compounds wherein T is of the Formula (VI): 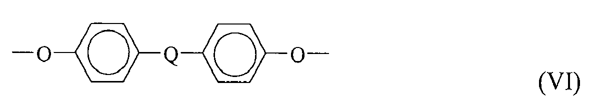 and the ether linkages, for example, can be in the 3,3', 3,4', 4,3', or 4,4' positions, and mixtures comprising at least one of the foregoing, and where Q is as defined above.

Any diamino compound may be employed. Examples of suitable compounds are ethylenediamine, propylenediamine, trimethylenediamine, diethylenetriamine, triethylenetertramine, hexamethylenediamine, heptamethylenediamine, octamethylenediamine, nonamethylenediamine, decamethylenediamine, 1,12-dodecanediamine, 1,18-octadecanediamine, 3-methylheptamethylenediamine, 4,4-dimethylheptamethylenediamine, 4-methylnonamethylenediamine, 5-methylnonamethylenediamine, 2,5-dimethylhexamethylenediamine, 2,5-dimethylheptamethylenediamine, 2, 2-dimethylpropylenediamine, N-methyl-bis (3-aminopropyl) amine, 3-methoxyhexamethylenediamine, 1,2-bis(3-aminopropoxy) ethane, bis(3-aminopropyl) sulfide, 1,4-cyclohexanediamine, bis-(4-aminocyclohexyl) methane, m-phenylenediamine, p-phenylenediamine, 2,4-diaminotoluene, 2,6-diaminotoluene, m-xylylenediamine, p-xylylenediamine, 2-methyl-4,6-diethyl-1,3-phenylene-diamine, 5-methyl-4,6-diethyl-1,3-phenylene-diamine, benzidine, 3,3'-dimethylbenzidine, 3,3'-dimethoxybenzidine, 1,5-diaminonaphthalene, bis(4-aminophenyl) methane, bis(2-chloro-4-amino-3, 5-diethylphenyl) methane, bis(4-aminophenyl) propane, 2,4-bis(b-amino-t-butyl) toluene, bis(p-b-amino-t-butylphenyl) ether, bis(p-b-methyl-o- aminophenyl) benzene, bis(p-b-methyl-o-aminopentyl) benzene, 1, 3-diamino-4-isopropylbenzene, bis(4-aminophenyl) sulfide, bis (4-aminophenyl) sulfone, and bis(4-aminophenyl) ether. Mixtures comprising at least one of these compounds may also be present. The diamino compounds can, specifically, be aromatic diamines. More specifically, the diamino compounds can be especially m- and p-phenylenediamine and mixtures comprising at least one of these compounds.

Generally, useful polyetherimides have a melt index of about 0.1 to about 10 grams per minute (g/min), as measured by American Society for Testing Materials (ASTM) D1238. The polyetherimide resin can have a weight average molecular weight (Mw) of about 5,000 to about 500,000 grams per mole (g/mole), more specifically a Mw of about 10,000 g/mole to about 80,000 g/mole, as measured by gel permeation chromatography, using a polystyrene standard. Such polyetherimide resins typically have an intrinsic viscosity greater than about 0.2 deciliters per gram (dl/g), preferably about 0.35 to about 0.7 dl/g measured in m-cresol at 25°C. Some such polyetherimides include, but are not limited to, ULTEM® 1000 (number average molecular weight (Mn) 21,000 g/mole; Mw 54,000 g/mole; dispersity 2.5), ULTEM® 1010 (Mn 19,000 g/mole; Mw 47,000 g/mole; dispersity 2.5), ULTEM® 1040 (Mn 12,000 g/mole; Mw 34,000 to 35,000 g/mole; dispersity 2.9), ULTEM® XH6050 (Mn 23,000-26,000 g/mole; Mw 52,000-58,000 g/mole; dispersity 2.2) (all commercially available from General Electric Plastics), or mixtures comprising at least one of the foregoing.

Suitable inorganic substances include, but are not limited to, silica, such as, for example, fumed silica and fused silica; aluminum oxide; zinc oxide; mica, such as for example, mica powder and plate mica; glass such as, for example, glass type A, and glass type E; carbon fiber; and nanoparticles, such as, for example, polymer-clay nanocomposites, oxo-metal nanocomposites, exfoliated nanocomposites; silicon dioxide; titanium dioxide; calcium sulfate; barium sulfate; calcium carbonate; fluropolymer; zeolite; carbon, for example carbon fiber and carbon nanotubes; silicates, for example talc; and a mixtures of at least two of the foregoing inorganic substances. In another embodiment, the fumed silica and the fused silica can be chemically treated. The silica can be treated with a silicone, for example, a fumed silica treated with dimethyl silicone fluid. The silica can also be treated with a silane, for example, a silane having at least one functional group. Silanes that can be used to treat silica, include but are not limited to, amino silane; phenyl silane; ester silane, for example, alkyl silane, methacryloxypropyl silane, acetoxypropyl silane; glycidoxypropyl silane, for example, derived from hydrosilating vinyl cyclohexene oxide; aminopropyl trimethoxysilanes, including amides and imides thereof; and mixtures thereof.

The inorganic substance has an average particle size that ranges from about 0.01 microns to about 2.0 microns, in an alternative embodiment from about 0.1 micron to about 2.0 microns, in another embodiment from about 0.2 microns to about 1.6 microns, and in yet an alternative embodiment from about 0.25 to about 1.6 microns, and all subranges therebetween.

Films of the polymer composition described above can be made via solution casting. Alternatively, if the inorganic substance can be combined with polyetherimide, for example, via melt mixing, then the film can be made by either extrusion or solution casting, as will be further described below.

In one embodiment a process for making a film includes preparing a casting solution containing solvent and a polymer composition containing polyetherimide and an inorganic substance; casting a layer of the casting solution onto a substrate; and removing solvent, for example, through evaporation, from the layer of casting solution. The casting solution can contain any of the polymer compounds in the example embodiments described above and solvent. For example, the polymer composition in the casting solution can contain by weight from about 50% to about 95% polyetherimide and from about 5% to about 50% inorganic substance. The relative amounts of polymer composition and solvent in the casting solution can vary depending upon the type of solvent used, the concentration of polyetherimide relative to the inorganic substance, and the molecular weight of polyetherimide. For example the casting solution can include from about 5% to about 30% by weight of polymer composition, and from about 70% to about 95% by weight solvent, and where the weight average molecular weight (Mw) of polyetherimide can range from about 34,000-65,000.

The casting solution can be made, for example, by preparing a dry mixture of polyetherimide particles and inorganic substance particles and then dissolving the mixture in solvent. Alternatively, the casting solution may be prepared by dissolving the polyetherimide in solvent to produce a polymer solution, dissolving the inorganic substance in solvent to produce and inorganic substance solution, and combining the polymer solution and the inorganic substance solution to produce the casting solution. One or more solvents can be used in preparing the polymer solution and one or more solvents can be used in preparing the inorganic substance solution, and the solvents can be the same or different.

In another embodiment the film can be made by melt compounding the polyetherimide and the inorganic substance to produce particles of the polymer composition, and then dissolving the particles in solvent to produce the casting solution. The polyetherimide in particles, for example in powder, pellet or another suitable form can be melt compounded at temperatures effective to render the resinous components molten and using, for example, a high shear mixer, such as an extruder, for example a twin-screw extruder, and inorganic substance is added to obtain a desirably uniform blend. Alternatively, the resin and inorganic substance components may first be combined in solid form, such as powder, or pellets, prior to melt compounding in order to facilitate mixing. For example, the dried resin and inorganic compound can be fed as a blend into a twin-screw extruder. The compound and polymer can be extruded through a strand dye into water, and then chopped to form pellets which can be ground and dissolved in the casting solution.

The casting solution can then be fed into a caster to make solvent cast films. Casting solution is spread as a thin film over a smooth substrate, for example, a glass substrate, and the solvent is permitted to evaporate for a controlled period of time ranging from a few seconds to as much as 24 hours or more at ambient conditions, however the time can depend upon the vapor pressure of the solvents employed and the evaporation conditions.

Any solvent that can dissolve polyetherimide and that can facilitate good dispersion of the inorganic substance can be used. Suitable solvents that can dissolve the polyetherimide and allows for good dispersion of inorganic substance at room temperature (about 20° to 35°C) and atmospheric pressure, include but are not limited to, acetophenone; anisole; chlorobenzene; dichlorobenzene (DCB), for example, ortho dichlorobenzene, para dichlorobenzene; xylene; toluene; mesitylene; dimethyl acrylamide; methylene chloride; polar aprotic solvent, such as, for example, N-(C₁-C₅₋alkyl)caprolactam (for example, N-methylcaprolactam, N-ethylcaprolactam, N-(n-propyl)caprolactam, N-(isopropyl)caprolactam), N-(C₁-C₅-alkyl)pyrrolidones (for example N-methyl pyrrolidone), N,N-dimethyl formamide, N,N-dimethyl acetamide, dimethyl sulfoxide, diphenyl sulfone, sulfolane, tetramethyl urea; and mixtures thereof.

The films produced via solution casting can vary in thicknesses, for example thicknesses of 150 microns or less, in an alternative embodiment from about 10 microns to about 150 microns, and yet in an alternative embodiment from about 10 microns to about 25 microns, while also having an average surface roughness (Ra) of about 2.0 microns or less, and in another embodiment, about 1.0 microns or less, and in alternative embodiments, about 0.7 microns or less, and in yet alternative embodiments about 0.45 microns or less, as measured according to ANSI B46.1.

Once the film is produced it can undergo a post heat treatment, for example, annealing, to ensure evaporation of solvent so that the film contains less that about 0.5% by weight, and preferably less than 0.2% by weight solvent.

The film of the present invention can also be made by extruding the polymer composition containing polyetherimide and inorganic substance in the embodiments described above using, for example, a single or a twin extruder. The polymer composition, for example in powder, pellet or another suitable form can be melted at temperatures effective to render the resinous components molten and extruding into a film. Alternatively, the inorganic substance can be melt compounded into the polyetherimide to produce the polymer composition as the film is being extruded.

The polymer composition can be extruded into a film having a thickness that is one of various thickness, for example a film thickness of about 750 microns or less, and having an average surface roughness (Ra) of about 1.0 microns or less, and in alternative embodiments about 0.45 microns or less.

The film according to the embodiments of the present invention, have a dielectric constant (Dk) of about 3.1 or less, in an alternative embodiment the dielectric constanc can range from about 2.8 to about 3.1, and in yet another embodiment the dielectric constant can range from about 2.8 to about 2.9.

In addition additives, for example, heat stabilizers, plasticizers, etc., may be incorporated into the polyetherimide, inorganic substance, or both, in one of many different methods, in methods that are well known in the art. For example, additives can physically mixed with the inorganic substance and the polyetherimide in powder or pellet form using conventional dry blending methods. In another example, the polyetherimide, the inorganic compound or both can be compouned in an extruder and the additives can be added to the molten composition through a port in the extruder, as is also commonly practiced in the art.

Film is produced via extrusion or solvent casting can further undergo a post heat treatment, for example, annealing, to reduce or eliminate built-in stress. The films produced herein can be used for several applications, which include but not limited to, insulation, for example cable insulation and wire wrapping; construction of motors; electronic circuits, for example flexible printed circuits; transformers; capacitors; coils; switches; separation membranes; computers; electronic and communication devices; telephones; headphones; speakers; recording and play back devices; lighting devices; printers; compressors; and the like. Optionally, the film can be metallized or partially metallized, as well as coated with other types of coatings designed to enhance physical, mechanical, and aesthetic properties, for example, to improve scratch resistance, surface lubricity, aesthetics, brand identification, structural integrity, and the like. For example, the films can be coated with printing inks, conductive inks, and similar other materials. Metallization processes include, for example, sputtering, metal vapor deposition, ion plating, arc vapor deposition, electroless plating, vacuum deposition, electroplating, and other methods. Additionally, the films can be employed in individual sheets or can be layered together to form more complex structures.

### EXAMPLES

Several samples of the film using the polymer composition according to example embodiments of the present invention were prepared as follows.

In examples 1 through 14 and 16 through 19 polymer compositions including polyetherimide and up to 40% by weight inorganic substances were dissolved in solvent and made into film via solution casting. In example 15 film was made by extruding the polymer composition. The thickness of the films produced varied from 10-150 microns. The coefficient of thermal expansion (CTE) and the average surface roughness (Ra) for each sample were measured and compared to one of the control samples, control A and control B, of unfilled polyetherimide.

The CTE of the films were measured after annealing the films at 150°C for about 12 hours. The CTE was measured using a thermo-mechanical analysis (TMA) instrument with a temperature range of 20°C to 200°C, and calculated using the slope of a linear fit to the TMA curve between 30°C and 150°C. The CTE were measured on film produced according to ASTM E 831-00 specification (and IPC-TM-650 2.4.41) using Q400 series TMA available from TMA Instruments, of New Castle, Delaware. Surface Roughness was measured according to ANSI B46.1 specification, cut off filter 800 microns, using the Dektak 3ST Stylus Profilometry, available from Veeco Instruments, formerly, Sloan Technologies, of Santa Barbara, California. Surface roughness of the films were measured on both the air side (Ra-1) and the substrate side (Ra-2) of the film.

A commercial lab scale caster was used to make solution cast films with a thickness that ranged from 10 microns to 150 microns. Films were cast on a smooth glass substrate and then removed with water. The concentration of the polymer composition relative to solvent was varied between 10% to 30% solids by weight depending on the weight average molecular weight of the PEI polymer which ranged from about 52,000 to about 57,000. The blade height of the solution caster was adjusted based on the per cent solids and solution to achieve the required thickness.

In Examples 1-7, films were made by dry mixing 15%-40% by weight fumed silica and 60%-85% by weight polyetherimide, and then dissolving the dry mix in methylene chloride solvent, and followed by solution casting. The film samples and Control A contained polyetherimide having a weight average molecular weight (Mw) of 52,000 to 57,000 available as Ultem 1000 from GE Plastics Company of Pittsfield, Massachusetts. In example 1 untreated fumed silica was used and was available as CAB-O-SIL™ M-5 from Cabot Corporation of Tuscola, Illinois. In examples 2-7 a high-purity fumed silica treated with dimethyl silicone fluid and was available as CAB-O-SIL™ TS-720 from Cabot Corporation. The average particle size of the fumed silica ranged from 0.2 to 0.3 microns. The results of the stylus profilometry and the CTE measurements of examples 1-7 are shown in Table 1.

In Examples 8-14, films were made melt compounding 10%-30% by weight fused silica and 70%-90% by weight polyetherimide to produce pellets of polymer composition. The polymer composition was then dissolved in methylene chloride and film was made via solution casting. The film samples and Control B contained polyetherimide having a weight average molecular weight (Mw) of 52,000 to 57,000 available as Ultem XH6050 from GE Plastics Company of Pittsfield, Massachusetts. In Examples 8 and 9 the films contained 10% by weight fused silica treated with amino silane and phenyl silane, respectively, with the treated fused silica having an average particle size of 1.6 microns. In examples 10-13 the films contained 10% by weight fused silica treated with amino silane with the treated fused silica having an average particle size of 0.25, 0.5, 1.0, and 1.6 microns, respectively. Treated fused silica available from Admatech of Japan was used in Examples 8-13 and untreated fused silica having an average particle size of 10 microns was available from Admatech was used in Example 14. In Example 15, the polymer composition containing, by weight, 70% polyetherimide and 30% fused silica having an average particle size of 1.6 microns was made into pellets by extruding the polyetherimide and the fused silica through a WP 30 millimeter twin-screw extruder. The pellets of polymer composition were then extruded into film. The results of the stylus profilometry and the CTE measurements of film containing unfilled polyetherimide in Control B and polyetherimide containing fused silica in examples 8-15 are shown in Table 1.

In examples 16-19, films were made by solution casting. Powders of polyetherimide and mica were dissolved separately in N-methylpyrrolidone (NMP) and then the solvent solutions were combined to produce a casting solution which contained 15%-30% by weight mica and 70%-85% polyetherimide, based on the combined solids weight of polyetherimide and mica. The films of examples 16-19 contained polyetherimide available as Ultem 1000 from GE Plastics Company. In examples 16-17, a general-purpose powder mica was used and was available from Gelest, Inc. of Morrisville, Pennsylvania. In examples 18-19 plate mica was used and was available as Powdered Muscovite from Gelest, Inc. The results of the CTE measurements of film containing containing powder mica and plate mica are shown in Table 1.

**Table 1**

| Example | Inorganic Substance (wt%) | CTE ppm/°C) | Ra-1 (nm) | Ra-2 (nm) |
|---|---|---|---|---|
| Control A | - | 55.0 | 93 | 102 |
| Control B | - | 52.0 | 196 | 148 |
| 1 | 15 | 43.1 | 1847 | 324 |
| 2 | 15 | 47.3 | 402 | 205 |
| 3 | 20 | 45.5 | 494 | 264 |
| 4 | 25 | 43.9 | 403 | 128 |
| 5 | 30 | 39.1 | 658 | 836 |
| 6 | 35 | 36.7 | - | - |
| 7 | 40 | 34.1 | - | - |
| 8 | 10 | 50.6 | 348 | 125 |
| 9 | 10 | 47.9 | 402 | 134 |
| 10 | 30 | 42.2 | 167 | 172 |
| 11 | 30 | 43.2 | 287 | 117 |
| 12 | 30 | 39.4 | 262 | 188 |
| 13 | 30 | 39.5 | 342 | 225 |
| 14 | 30 | 44.7 | 237 | 284 |
| 15 | 30 | 42.0 | 399 | 399 |
| 16 | 15 | 31.9 | - | - |
| 17 | 30 | 25.6 | - | - |
| 18 | 15 | 25.8 | - | - |
| 19 | 20 | 24.4 | - | - |

A comparison of the data of examples 1-7 and Control A show that there was a 14% to 38% reduction in CTE in samples containing from 15% to 40% by weight fumed silica compared to the unfilled polyetherimide of Control A. A comparison of the data of examples 8-15 and Control B show there was a 2.7% to 24.2% reduction in CTE in samples containing 10%-30% by weight fused silica compared to the unfilled polyetherimide of Control B. A comparison of the data of examples 16-19 and Control A show there was a 41.9% to 55.7% reduction in CTE in samples containing 15%-30% by weight mica compared to the unfilled polyetherimide of Control B.

Although the invention is shown and described with respect to certain embodiments, it is obvious that equivalents and modifications will occur to others skilled in the art upon the reading and understanding of the specification. The present invention includes all such equivalents and modifications, and is limited only by the scope of the claims.

## Claims

1. A polymer composition, comprising by weight:
from 50% to 95% of a polyetherimide resin;
from 5% to 50% inorganic substance; and
wherein the polymer composition when converted into a film, has a CTE of less than 50 ppm/°C.

2. The polymer composition of claim 1, wherein the polymer composition comprises from 10% to 40% polyetherimide resin and the film has a CTE that ranges from 48 to 24 ppm/°C.

3. The polymer composition of claim 1 or 2, wherein the film has an average surface roughness of 2.0 microns or less according to ANSI B46.1.

4. The polymer composition of any one of the claims 1, 2 or 3 wherein the inorganic substance is selected from the group consisting of: aluminum oxide, zinc oxide, mica, silica, glass, carbon, nanocomposites, silicon dioxide, titanium dioxide, calcium sulfate, barium sulfate, calcium carbonate, fluropolymer, zeolite, silicates, and mixtures thereof.

5. The polymer composition of claims 1, 2, 3, or 4, wherein the polyetherimide resin comprises repeating units having the following formula 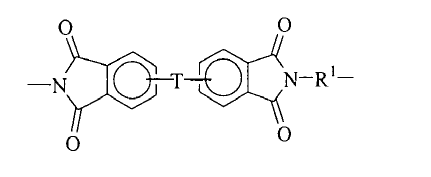 where T and R¹ are independently selected from substituted and unsubstituted divalent aromatic radicals.

6. A film comprising the polymer compositions of any one of the claims 1, 2, 3, 4, or 5.

7. The film of claim 6, wherein the film has a thickness that is 750 microns or less.

8. The film of claims 6 or 7, wherein the inorganic substance is selected from the group consisting of: aluminum oxide, zinc oxide, mica, silica, glass, nanocomposites, and mixtures thereof.

9. A process for making a polymer film, the process comprising the steps of:
preparing a casting solution comprising solids and solvent, wherein the solids comprise, by weight:
from 50-95% polyetherimide and
from 5% to 50% inorganic substance;
casting a layer of the casting solution onto a substrate; and
removing solvent from the layer of casting solution.

10. An article comprising:
a substrate; and
the film of any of claims 6, 7 or 8 disposed on the substrate.
